# EUROPEAN PATENT APPLICATION

(11) **EP 4 607 222 A1**
(43) Date of publication of application: **27.08.2025**
(21) Application number: 23878603.2
(22) Date of filing: 28.04.2023
(51) Int. Cl.: G01R 31/396, G01R 31/3835

(54) **ENERGY STORAGE SYSTEM AND SOC CORRECTION METHOD THEREFOR**

(30) Priority: 19.10.2022 CN 202211291633
(71) Applicant: Sungrow Power Supply Co., Ltd., Hefei, Anhui 230088 (CN)
(72) Inventor: ZHOU, Jianjie, Hefei, Anhui 230088 (CN); CHEN, Fanglin, Hefei, Anhui 230088 (CN); CAO, Xiaohui, Hefei, Anhui 230088 (CN); CAI, Zhuang, Hefei, Anhui 230088 (CN)
(74) Representative: Zacco Norway AS
(86) International application number: PCT/CN2023/091628
(87) International publication number: WO 2024/082604

(57) **Abstract**

Provided in the present application are an energy storage system and an SOC correction method therefor. The SOC correction method comprises: determining whether an energy storage system is in a double-voltage plateau interval of a lithium manganese iron phosphate battery cell; and when the energy storage system is in the double-voltage plateau interval, correcting an SOC of the lithium manganese iron phosphate battery cell according to the SOC of the lithium manganese iron phosphate battery cell. Therefore, by using the double-voltage plateau characteristic of a lithium manganese iron phosphate battery cell, each time the lithium manganese iron phosphate battery cell is charged and discharged, an SOC correction point located within a middle section of a plateau of the lithium manganese iron phosphate battery cell can be provided therefor, thereby avoiding a long-term accumulative deviation and improving the accuracy of SOC estimation. Moreover, by using the high-voltage plateau feature of lithium manganese iron phosphate, a PCS direct-current access voltage can be better adapted to, the voltage utilization rate is improved, and an energy storage system still maintains an active grid connection under high voltage ride through of a power grid. In addition, the wide-temperature operation performance of an energy storage battery system can also be improved by using the good low-temperature characteristic of lithium manganese iron phosphate.

## Description

This application claims the priority to Chinese patent application No. 202211291633.3, titled "ENERGY STORAGE SYSTEM AND SOC CORRECTION METHOD THEREFOR", filed on October 19, 2022 with the China National Intellectual Property Administration, which is incorporated herein by reference in its entirety.

### FIELD

The present disclosure relates to the technical field of power electronics, and in particular to an energy storage system and an SOC correction method for the energy storage system.

### BACKGROUND

Currently, lithium iron phosphate batteries are widely used in large-scale grid-connected energy storage. An SOC (State of Charge, also known as remaining power) of the lithium iron phosphate battery is difficult to be accurately estimated due to a long plateau phase of an OCV (Open circuit voltage) of lithium iron phosphate and limitation of conventional software algorithms, and the SOC is estimated at the end of charging and discharging due to a long-term accumulated deviation, to eliminate factor errors.

Therefore, a solution for improving the estimation accuracy of the SOC of the lithium iron phosphate battery is urgently required.

### SUMMARY

An energy storage system and an SOC correction method for the energy storage system are provided in the present disclosure, to improve the estimation accuracy of the SOC of the lithium iron phosphate battery.

In order to achieve the foregoing objective, the following technical solutions are provided according to the present disclosure.

In a first aspect, an SOC correction method for an energy storage system is provided in the present disclosure. The energy storage system includes at least one lithium manganese iron phosphate battery unit and at least one lithium iron phosphate battery unit connected in series; and the SOC correction method includes: determining whether the energy storage system is in an interval between two voltage plateau phases of the lithium manganese iron phosphate battery unit; and correcting an SOC of the lithium iron phosphate battery unit based on an SOC of the lithium manganese iron phosphate battery unit in response to the energy storage system in the interval between the two voltage plateau phases.

In an embodiment, the correcting an SOC of the lithium iron phosphate battery unit based on an SOC of the lithium manganese iron phosphate battery unit includes determining the SOC of the lithium manganese iron phosphate battery unit as the SOC of the lithium iron phosphate battery unit.

In an embodiment, the correcting an SOC of the lithium iron phosphate battery unit based on an SOC of the lithium manganese iron phosphate battery unit includes correcting the SOC of the lithium iron phosphate battery unit based on a parameter of a curve segment corresponding to the interval between the two voltage plateau phases in an open circuit voltage, OCV, curve of the lithium manganese iron phosphate battery unit, and a voltage of the lithium iron phosphate battery unit.

In an embodiment, the parameter of the curve segment includes a voltage and an SOC. The correcting the SOC of the lithium iron phosphate battery unit based on a parameter of a curve segment and a voltage of the lithium iron phosphate battery unit includes determining a slope of the curve segment based on the voltage and the SOC corresponding to the curve segment; and determining the SOC of the lithium iron phosphate battery unit based on the slope of the curve segment and the voltage of the lithium iron phosphate battery unit.

In an embodiment, the determining whether the energy storage system is in an interval between two voltage plateau phases of the lithium manganese iron phosphate battery unit includes determining whether a voltage of the lithium manganese iron phosphate battery unit is between a minimum voltage of a first voltage plateau phase and a maximum voltage of a second voltage plateau phase, where the minimum voltage of the first voltage plateau phase is greater than the maximum voltage of the second voltage plateau phase; and determining the energy storage system is in the interval between the two voltage plateau phases in response to the voltage of the lithium manganese iron phosphate battery unit between the minimum voltage of the first voltage plateau phase and the maximum voltage of the second voltage plateau phase.

In an embodiment, each of the at least one lithium manganese iron phosphate battery unit and the at least one lithium iron phosphate battery unit is a cell or a battery pack.

In an embodiment, the SOC correction method for an energy storage system further includes determining whether the energy storage system is at an end of charging and discharging; and performing a conventional SOC correction on each of the at least one lithium manganese iron phosphate battery unit and the at least one lithium iron phosphate battery unit of the energy storage system in response to the energy storage system at the end of charging and discharging.

In a second aspect, an energy storage system is provided in the present disclosure, including: a battery management system, BMS, and at least one battery cluster controlled by the BMS, where the battery cluster includes one battery pack or at least two battery packs connected in series; the one battery pack or the at least two battery packs includes one cell or at least two cells connected in series; at least one of the one battery pack or the at least two battery packs includes at least one lithium iron phosphate cell; at least one of the one battery pack or the at least two battery packs includes at least one lithium manganese iron phosphate cell; and the BMS is configured to perform the SOC correction method for an energy storage system according to any one of the first aspect.

In an embodiment, the battery cluster includes the at least two battery packs connected in series; and in two adjacent battery packs of the at least two battery packs, one of the two adjacent battery packs includes only the lithium manganese iron phosphate cell, and the other battery pack of the two adjacent battery packs includes only the lithium iron phosphate cell.

In an embodiment, the battery cluster includes the at least two battery packs connected in series, where at least one of the at least two battery packs includes only the lithium manganese iron phosphate cell; and the other battery pack of the at least two battery packs includes only the lithium iron phosphate cell.

In an embodiment, each of the one battery pack or at least two battery packs includes at least two cells connected in series, and two adjacent cells of the at least two cells are the lithium manganese iron phosphate cell and the lithium iron phosphate cell.

In an embodiment, each of the one battery pack or at least two battery packs includes at least two cells connected in series; at least one of the at least two cells is the lithium manganese iron phosphate cell; and the other cell of the at least two cells is the lithium iron phosphate cell.

In an embodiment, the energy storage system further includes a power conversion system, PCS, or a DC/DC converter. The at least one battery cluster is connected to a direct-current side of the PCS or a battery side of the DC/DC converter; an alternating-current side of the PCS is configured to connect a power grid and/or a load; and a bus side of the DC/DC converter is configured to connect a direct-current bus of a renewable energy grid-connected power generation system.

With the SOC correction method for the energy storage system according to this present disclosure, it is determined whether the energy storage system is in an interval between two voltage plateau phases of the lithium manganese iron phosphate battery unit, and an SOC of the lithium iron phosphate battery unit is corrected based on an SOC of the lithium manganese iron phosphate battery unit in response to the energy storage system in the interval between the two voltage plateau phases, thus providing an SOC correction point in the interval between the two voltage plateau phases for the lithium iron phosphate battery unit each time the lithium iron phosphate battery unit is charged and discharged by using the characteristic of the two voltage plateau phases of the lithium manganese iron phosphate battery unit, thereby avoiding a long-term accumulated deviation and improving the estimation accuracy of the SOC.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.
FIG. 1 is a flowchart of an SOC correction method for an energy storage system according to an embodiment of the present disclosure;
FIG. 2 is a waveform diagram of OCV curves of a lithium manganese iron phosphate cell and a lithium iron phosphate cell according to an embodiment of the present disclosure;
FIG. 3 is a schematic structural diagram of an energy storage system according to an embodiment of the present disclosure;
FIG. 4 is a schematic structural diagram of an energy storage system according to another embodiment of the present disclosure;
FIG. 5 is a schematic structural diagram of an energy storage system according to another embodiment of the present disclosure; and
FIG. 6 is a schematic structural diagram of an energy storage system according to another embodiment of the present disclosure.

### DETAILED DESCRIPTION

The technical solutions according to the embodiments of the present disclosure are described clearly and completely as follows in conjunction with the drawings in the embodiments of the present disclosure. It is apparent that the described embodiments are only some of the embodiments of the present disclosure, rather than all the embodiments. Any other embodiments obtained by those skilled in the art based on the embodiments of the present disclosure without any creative work fall within the protection scope of the present disclosure.

In the present disclosure, the terms "include", "comprise" or any other variants thereof are intended to be non-exclusive. Therefore, a process, method, article or device including a series of elements include not only these elements but also other elements that are not clearly enumerated, or further include elements inherent in the process, method, article or device. Unless expressively limited, the statement "including a..." does not exclude the case that other similar elements may exist in the process, method, article or device including the series of elements.

An SOC correction method for an energy storage system is provided in the present disclosure, to improve the estimation accuracy of the SOC of the lithium iron phosphate battery.

The energy storage system includes at least one lithium manganese iron phosphate battery unit and at least one lithium iron phosphate battery unit connected in series. Meanwhile, in a series branch, the number of each of the two battery units and an order in which the two battery units are connected to each other are not limited. In addition, in practical applications, each battery unit may refer to a cell, or may refer to a battery pack, depending on the application environment. All implementations fall within the protection scope of the present disclosure.

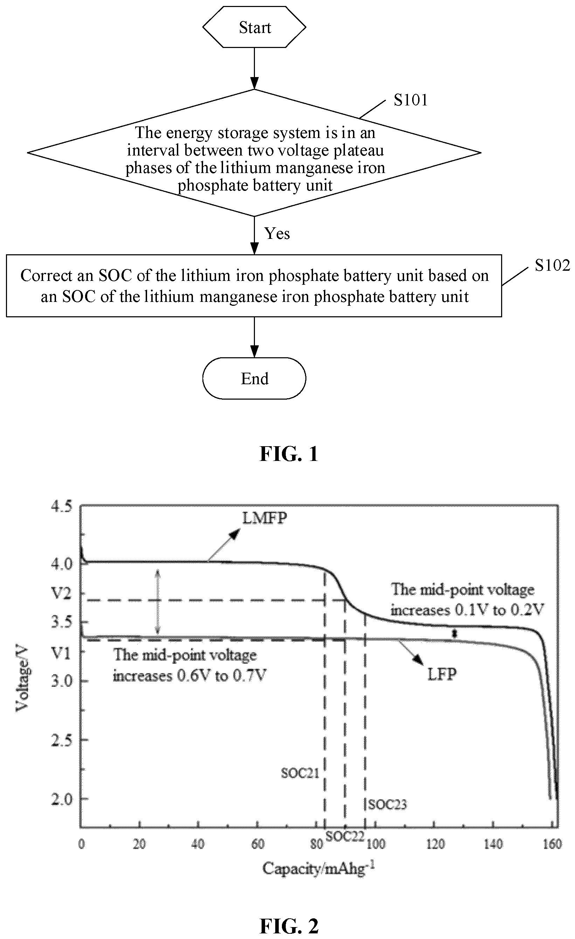

As shown in FIG. 1, the SOC correction method for the energy storage system includes the following S101 and S102.

In S101, it is determined whether the energy storage system is in an interval between two voltage plateau phases of the lithium manganese iron phosphate battery unit.

FIG. 2 shows OCV curves of an LMFP (LiFexMn1-xPO4, lithium manganese iron phosphate) cell and an LFP (LiFePO4, lithium iron phosphate) cell. As shown in FIG. 2, the OCV curve of the LMFP cell has two plateau phases, namely: a first voltage plateau phase in which a voltage is about 4V, and a second voltage plateau phase in which a voltage is about 3.5V. A minimum voltage of the first voltage plateau phase is greater than a maximum voltage of the second voltage plateau phase. An interval phase exists between the two plateau phases, corresponding to a middle section between the two plateau phases in the OCV curve of the LFP cell, i.e., about 50% of the plateau phase.

It is determined whether the energy storage system is in the interval phase, that is, the interval between the two voltage plateau phases of the lithium manganese iron phosphate battery unit by determining whether a voltage of the lithium manganese iron phosphate battery unit is between the minimum voltage of the first voltage plateau phase and the maximum voltage of the second voltage plateau phase. If the voltage of the lithium manganese iron phosphate battery unit is between the minimum voltage and the maximum voltage, it is determined that the energy storage system is in the interval between the two voltage plateau phases, and S102 is performed.

It should be noted that if each battery unit is the cell, the minimum voltage of the first voltage plateau phase may be 4V as shown in FIG. 2, and the maximum voltage of the second voltage plateau phase may be 3.5V as shown in FIG. 2. If each battery unit is the battery pack, the minimum voltage of the first voltage plateau phase may be 4nV, and the maximum voltage of the second voltage plateau phase may be 3.5nV, where n represents the number of cells in the battery pack. In practical applications, parameters of the two plateau phases may be determined based on a specification of the lithium manganese iron phosphate cell, and are not limited to the parameter examples shown in FIG. 2.

In S102, an SOC of the lithium iron phosphate battery unit is corrected based on an SOC of the lithium manganese iron phosphate battery unit.

In practical applications, the SOC of the lithium manganese iron phosphate battery unit may be directly determined as the SOC of the lithium iron phosphate battery unit. Reference is made to FIG. 2, and discharge is taken as an example.

The SOC of the lithium iron phosphate cell is defined as SOC1, and the SOC of the lithium manganese iron phosphate cell is defined as SOC2. If a BMS (Battery Management System) detects that the voltage v of the lithium manganese iron phosphate cell changes from 4.1V towards 4V, SOC2 is equal to SOC21, such as 60%. In this condition, SOC1 of the lithium iron phosphate cell is forced to be corrected, that is, SOC1=60%. If the BMS detects that the voltage v of the lithium manganese iron phosphate cell is equal to V2, SOC2 of the lithium manganese iron phosphate cell is equal to SOC22, such as 50%. In this condition, SOC1 of the lithium iron phosphate cell is forced to be corrected, that is, SOC1=50%. If the BMS detects that the voltage v of the lithium manganese iron phosphate cell changes from V2 towards 3.5V, SOC2 of the lithium manganese iron phosphate cell is equal to SOC23, such as 40%. In this condition, SOC1 of the lithium iron phosphate cell is forced to be corrected, that is, SOC1=40%. V1 in FIG. 2 represents the voltage of the lithium iron phosphate cell corresponding to the voltage V2 of the lithium manganese iron phosphate cell.

With the SOC correction method for the energy storage system in this embodiment, based on the above principle, an SOC correction point in the interval between the plateau phases is provided for the lithium iron phosphate battery unit each time the lithium iron phosphate battery unit is charged and discharged by using the characteristic of the two voltage plateau phases of the lithium manganese iron phosphate battery unit, thereby avoiding a long-term accumulated deviation and improving the estimation accuracy of SOC.

In practical applications, the SOC correction method may retain the conventional SOC correction, that is, the SOC correction method further includes: determining whether the energy storage system is at an end of charging and discharging; and performing a conventional SOC correction on each battery unit of the energy storage system in response to the energy storage system at the end of charging and discharging. In this condition, if each battery unit is the cell, compared with a battery pack including only the lithium iron phosphate cell of which the SOC is corrected only at the end of charging and discharging, in the present disclosure, on this basis, the SOC correction point at about 50% of the plateau phase is provided for a battery pack with mixed cells by using the two voltage plateau phases of the lithium manganese iron phosphate. Similarly, if each battery unit is the battery pack, an SOC correction point at the middle section is additionally provided for the battery cluster with mixed battery packs in the present disclosure.

Based on the previous embodiment, in an embodiment, the step S102 in the SOC correction method for the energy storage system includes: correcting the SOC of the lithium iron phosphate battery unit based on a parameter of a curve segment corresponding to the interval between the two voltage plateau phases in the OCV curve of the lithium manganese iron phosphate battery unit, and a voltage of the lithium iron phosphate battery unit.

Where the parameter of the curve segment includes a voltage and an SOC. The process of this step includes steps (1) and (2).
In step (1), a slope of the curve segment is determined based on the voltage and the SOC corresponding to the curve segment; and
In step (2), the SOC of the lithium iron phosphate battery unit is determined based on the slope of the curve segment and the voltage of the lithium iron phosphate battery unit.

The battery unit being a cell is taken as an example. The SOC of the lithium iron phosphate cell is defined as SOC1, and the SOC of the lithium manganese iron phosphate cell is defined as SOC2. For the OCV curves of the two types of cells shown in FIG. 2, a functional relationship between SOC and voltage of each cell may be established.

For the lithium iron phosphate cell, SOC1=f1(v).

For the lithium manganese iron phosphate cell, SOC2=f2(v).

Through the correction correspondence described in the previous embodiment, it can be seen that: SOC2=f2(v)=k×v in a case that the voltage ranges from 3.5V to 4V, where k represents the slope of this curve. k=(SOC21-SOC23)/(4-3.5)=2×(SOC21-SOC23), and SOC1 in this section is obtained as SOC1=f1(v)=k×v=2×(SOC21-SOC23)×v.

Therefore, in practical applications, during the interval between two voltage plateau phases of the lithium manganese iron phosphate battery unit, the corrected SOC can be calculated based on the voltage of the lithium iron phosphate battery unit in a real time manner.

An energy storage system is further provided in another embodiment of the present disclosure, including: a BMS and at least one battery cluster controlled by the BMS. The battery cluster includes one battery pack or at least two battery packs connected in series. Generally, the battery cluster includes multiple battery packs connected in series. The battery pack includes one cell or at least two cells connected in series. In practical applications, the battery pack generally includes multiple battery modules connected in series, and each of the battery modules includes multiple cells connected in series.

Compared with the conventional energy storage system, the energy storage system in the present disclosure includes at least one battery pack including at least one lithium iron phosphate cell, and further includes at least one battery pack including at least one lithium manganese iron phosphate cell. Furthermore, the BMS is configured to perform the SOC correction method for an energy storage system according to any one of the embodiments described above. The process and principle of the SOC correction method are referred to the above embodiments, and are not repeated here.

Furthermore, the energy storage system may further include a PCS (Power Conversion System), or a DC/DC converter. Where each battery cluster is connected to a direct-current side of the PCS or a battery side of the DC/DC converter, and an alternating-current side of the PCS is configured to connect a power grid and/or a load. A bus side of the DC/DC converter is configured to connect a direct-current bus of a renewable energy grid-connected power generation system.

In practical applications, the battery cluster in the energy storage system is implemented in many forms, such as examples (1), (2), (3) and (4) described hereinafter.
(1) The battery cluster includes at least two battery packs connected in series. In two adjacent battery packs, one of the two adjacent battery packs includes only the lithium manganese iron phosphate (hereinafter referred to as LMFP) cell, and the other battery pack of the two adjacent battery packs includes only the lithium iron phosphate (hereinafter referred to as LFP) cell.

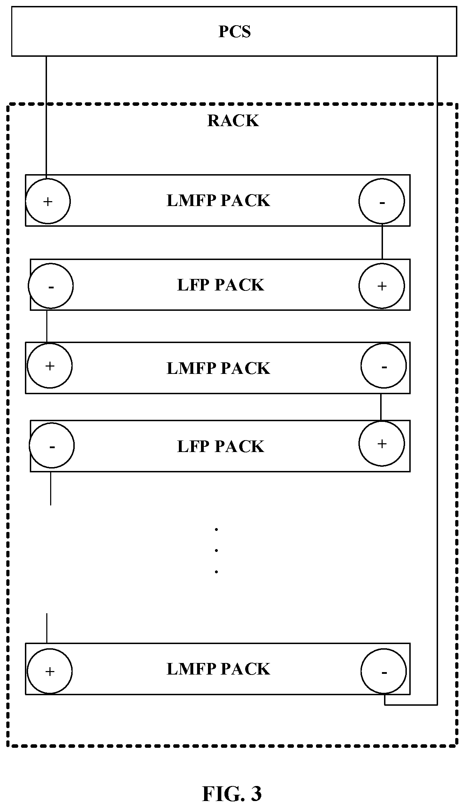

As shown in FIG. 3, the battery pack (LMFP PACK shown in FIG. 3) including the LMFP cells and the battery pack including the LFP cells (LFP PACK shown in FIG. 3) are alternately connected in series to form a battery cluster (RACK shown in FIG. 3). An SOC of the LFP battery pack is corrected based on an SOC of the adjacent LMFP battery pack with the SOC correction method described above, thus increasing the SOC correction point.

Moreover, for the battery cluster in this form, the application where half of cells are the LFP cells greatly reduces an operating voltage window of the battery cluster. As can be seen from FIG. 2, in the first voltage plateau phase of the LMFP cell, the LMFP cell is 0.6V to 0.7V greater than the LFP cell in the midpoint voltage; and in the second voltage plateau phase of the LMFP cell, the LMFP cell is 0.1V to 0.2V greater the LFP cell in the midpoint voltage. If an operating voltage the LMFP cell ranges from 2.7V to 4.1V, and 384 cells are connected in series to form a battery cluster with a voltage ranging from 1123.2V to 1574.4V, and the upper limit of the voltage exceeds a limit 1500VDC of a direct-current side voltage of a conventional PCS. If half of cells in the battery cluster are LFP cells, the operating voltage of the battery cluster ranges from 1123.2V to 1488V, fully utilizing the upper limit of the direct-current side voltage of the PCS. A plateau voltage of the LMFP cell is increased, better meeting the requirement of active grid connection of the PCS during high voltage ride-through of the power grid.

In practical applications, the steps of determining the number of the LMFP cell in the battery cluster may include: determining an upper limit U0 of the direct-current voltage, which is described below by taking U0=1500V as an example; determining an upper limit U1 of a port voltage of the battery cluster, where an initial value of U1 is U0; determining an upper limit U11 of the voltage of the single LMFP cell, taking U11=4.1V as an example; determining a lower limit U12 of the voltage of the single LMFP cell, taking U12=3.5V as an example; determining an upper limit U21 of the voltage of the single LFP cell, taking U21=3.65V as an example; determining a lower limit U22 of the voltage of the single LFP cell, taking U22=2.7V as an example; determining the number Y0 of the battery cluster of including LFP cells alone, then Y0=U1/U21=410; calculating the number of LMFP cell as X=INT((U1-U21×Y)/U11)=INT((1500-3.65×Y)/4.1), where INT represents an identifier for defining a variable with an integer type, an initial value of Y is Y0 and the value of Y gradually decreases. Then the value of X is calculated accordingly, and the lower limit U2 of the port voltage of the corresponding battery cluster is obtained as shown in Table 1, where RACK in Table 1 represents the battery cluster.

**Table 1 Example of the numbers of the LMFP cell and the LFP cell in the battery cluster**

| Numbe r Y of LFP cells | Numbe r X of LMFP cells | Lower limit U22/V of voltage of LFP cell | Lower limit U12/V of voltage of LMFP cell | Upper limit U21/V of voltage of LFP cell | Upper limit U11/N of voltage of LMFP cell | Lower limit U2/N of port voltage of RACK | Upper limit U1/V of port voltage of RACK | Upper limit U1/V of DC voltage | Range V of DC voltage | Increase percentage of lower limit U2 of port voltage of RACK (compared with LFP alone) | Decrease percentage of port voltage change of RACK (compared with LFP alone) | Number difference of LFP and LMFP | Total number of cells in RACK |
|---|---|---|---|---|---|---|---|---|---|---|---|---|---|
| 410 | 0 | 2.7 | 3.5 | 3.65 | 4.1 | 1107 | 1496.5 | 1500 | 393 | 0.00% | 0.00% | 410 | 410 |
| 409 | 1 | 2.7 | 3.5 | 3.65 | 4.1 | 1107.8 | 1496.95 | 1500 | 392.2 | 0.07% | -0.20% | 408 | 410 |
| 408 | 2 | 2.7 | 3.5 | 3.65 | 4.1 | 1108.6 | 1497.4 | 1500 | 391.4 | 0.14% | -0.41% | 406 | 410 |
| 407 | 3 | 2.7 | 3.5 | 3.65 | 4.1 | 1109.4 | 1497.85 | 1500 | 390.6 | 0.22% | -0.61% | 404 | 410 |
| 406 | 4 | 2.7 | 3.5 | 3.65 | 4.1 | 1110.2 | 1498.3 | 1500 | 389.8 | 0.29% | -0.81% | 402 | 410 |
| 405 | 5 | 2.7 | 3.5 | 3.65 | 4.1 | 1111 | 1498.75 | 1500 | 389 | 0.36% | -1.02% | 400 | 410 |
| 404 | 6 | 2.7 | 3.5 | 3.65 | 4.1 | 1111.8 | 1499.2 | 1500 | 388.2 | 0.43% | -1.22% | 398 | 410 |
| 403 | 7 | 2.7 | 3.5 | 3.65 | 4.1 | 1112.6 | 1499.65 | 1500 | 387.4 | 0.51% | -1.42% | 396 | 410 |
| 402 | 7 | 2.7 | 3.5 | 3.65 | 4.1 | 1109.9 | 1496 | 1500 | 390.1 | 0.26% | -0.74% | 395 | 409 |
| 401 | 8 | 2.7 | 3.5 | 3.65 | 4.1 | 1110.7 | 1496.45 | 1500 | 389.3 | 0.33% | -0.94% | 393 | 409 |
| 400 | 9 | 2.7 | 3.5 | 3.65 | 4.1 | 1111.5 | 1496.9 | 1500 | 388.5 | 0.41% | -1.15% | 391 | 409 |
| 399 | 10 | 2.7 | 3.5 | 3.65 | 4.1 | 1112.3 | 1497.35 | 1500 | 387.7 | 0.48% | -1.35% | 389 | 409 |
| 384 | 24 | 2.7 | 3.5 | 3.65 | 4.1 | 1120.8 | 1500 | 1500 | 379.2 | 1.25% | -3.51% | 360 | 408 |
| 194 | 193 | 2.7 | 3.5 | 3.65 | 4.1 | 1199.3 | 1499.4 | 1500 | 300.7 | 8.34% | -23.49% | 1 | 387 |
| 193 | 194 | 2.7 | 3.5 | 3.65 | 4.1 | 1200.1 | 1499.85 | 1500 | 299.9 | 8.41% | -23.69% | -1 | 387 |
| 10 | 356 | 2.7 | 3.5 | 3.65 | 4.1 | 1273 | 1496.1 | 1500 | 227 | 15.00% | -42.24% | -346 | 366 |
| 9 | 357 | 2.7 | 3.5 | 3.65 | 4.1 | 1273.8 | 1496.55 | 1500 | 226.2 | 15.07% | -42.44% | -348 | 366 |
| 8 | 358 | 2.7 | 3.5 | 3.65 | 4.1 | 1274.6 | 1497 | 1500 | 225.4 | 15.14% | -42.65% | -350 | 366 |
| 7 | 359 | 2.7 | 3.5 | 3.65 | 4.1 | 1275.4 | 1497.45 | 1500 | 224.6 | 15.21% | -42.85% | -352 | 366 |
| 6 | 360 | 2.7 | 3.5 | 3.65 | 4.1 | 1276.2 | 1497.9 | 1500 | 223.8 | 15.28% | -43.05% | -354 | 366 |
| 5 | 361 | 2.7 | 3.5 | 3.65 | 4.1 | 1277 | 1498.35 | 1500 | 223 | 15.36% | -43.26% | -356 | 366 |
| 4 | 362 | 2.7 | 3.5 | 3.65 | 4.1 | 1277.8 | 1498.8 | 1500 | 222.2 | 15.43% | -43.46% | -358 | 366 |
| 3 | 363 | 2.7 | 3.5 | 3.65 | 4.1 | 1278.6 | 1499.25 | 1500 | 221.4 | 15.50% | -43.66% | -360 | 366 |
| 2 | 364 | 2.7 | 3.5 | 3.65 | 4.1 | 1279.4 | 1499.7 | 1500 | 220.6 | 15.57% | -43.87% | -362 | 366 |
| 1 | 364 | 2.7 | 3.5 | 3.65 | 4.1 | 1276.7 | 1496.05 | 1500 | 223.3 | 15.33% | -43.18% | -363 | 365 |
| 0 | 365 | 2.7 | 3.5 | 3.65 | 4.1 | 1277.5 | 1496.5 | 1500 | 222.5 | 15.40% | -43.38% | -365 | 365 |

Table 1 only shows some solutions for setting the number of the two types of cells in the battery cluster. Through the above calculation process and some examples shown in Table 1, the lower limit U2 of the port voltage is obtained when both X and Y are maximum, that is, X=194, Y=193, or X=193, Y=194. In this condition, the lower limit U2 of the port voltage is equal to 1200V, and the upper limit U1 of the port voltage is obtained as X*U11+Y*U21=1499V. Compared with the battery cluster including the LFP cell alone, the lower limit U2 of the port voltage is increased by more than 15%. A maximum lower limit U2 of the port voltage is most beneficial to maintaining an active output under high voltage ride-through fault of the power grid.

(2) The battery cluster includes at least two battery packs connected in series, at least one of the battery packs includes the lithium manganese iron phosphate cell alone, and other battery pack includes the lithium iron phosphate cell alone.

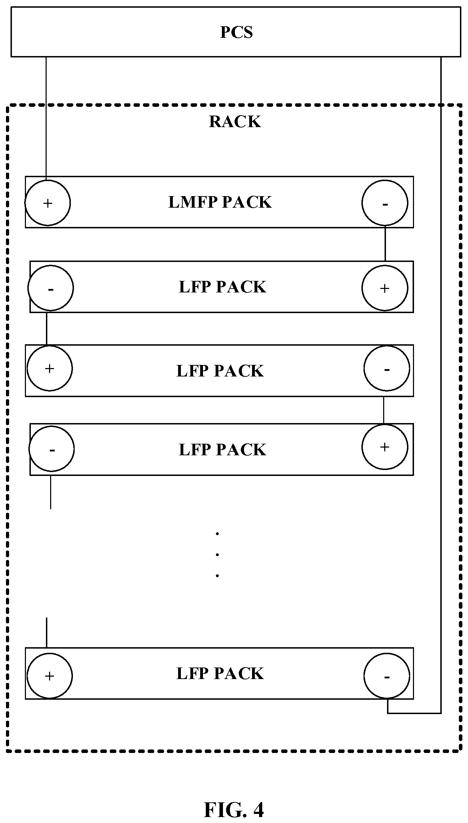

As shown in FIG. 4, battery packs (LFP PACK shown in FIG. 4) formed by lithium iron phosphate cells are connected in series, and a battery pack (LMFP PACK shown in FIG. 4) formed by the lithium manganese iron phosphate cell is connected in series with the battery packs at any position (at a head end of a branch formed by the battery packs connected in series shown in FIG. 4 as an example) to form a battery cluster (RACK shown in FIG. 4). With the SOC correction method described above, the SOC of the battery pack including the lithium iron phosphate cell is corrected based on the SOC of the battery pack including lithium manganese iron phosphate cell in the battery cluster.

(3) Each battery pack includes at least two cells connected in series, and two adjacent cells are the lithium manganese iron phosphate cell and the lithium iron phosphate cell.

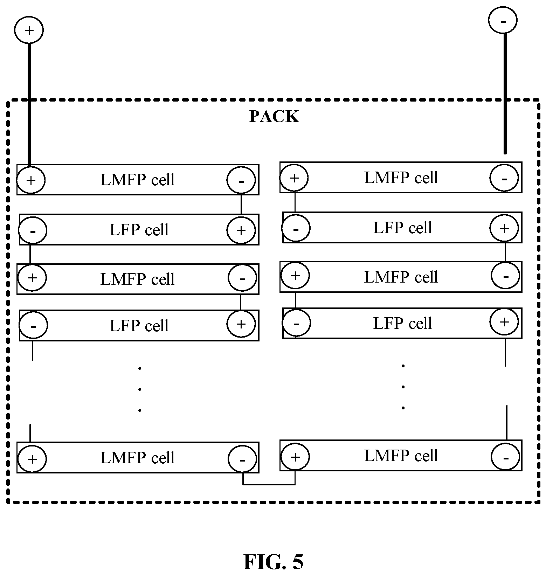

As shown in FIG. 5, lithium manganese iron phosphate cells (LMFP cells shown in FIG. 5) and lithium iron phosphate cells (LFP cells shown in FIG. 5) are alternately connected in series to form a battery pack (PACK shown in FIG. 5), and then the multiple battery packs with the mixed cells are connected in series to form a battery cluster.

In this condition, the SOC of the lithium iron phosphate cell is corrected based on the SOC of the adjacent lithium manganese iron phosphate cell with the SOC correction method described above.

(4) Each battery pack includes at least two cells connected in series; at least one of the at least two cells is the lithium manganese iron phosphate cell; and the other cell of the at least two cells is the lithium iron phosphate cell.

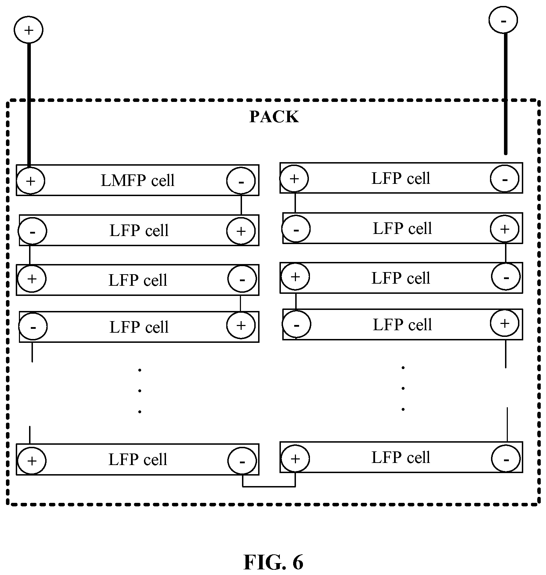

As shown in FIG. 6, multiple lithium iron phosphate cells (LFP cells shown in FIG. 6) are connected in series, and the lithium manganese iron phosphate cell (LMFP cell shown in FIG. 6) is connected in series with the multiple lithium iron phosphate cells at any position (at a head end of a branch formed by the multiple lithium iron phosphate cells connected in series shown in FIG. 6) to form a battery pack (PACK shown in FIG. 6). The multiple battery packs with the mixed cells are connected in series to form a battery cluster. With the SOC correction method described above, the SOC of the lithium iron phosphate cell is corrected based on the SOC of the lithium manganese iron phosphate cell in the battery pack.

The SOC correction point can be increased by all the implementation forms described above. Moreover, the direct-current input voltage of the PCS can be better adapted by using the characteristics of the high-voltage plateau phase of the lithium manganese iron phosphate, so as to improve voltage utilization, and ensure the energy storage system to maintain active grid connection under high voltage ride-through of the power grid. Furthermore, under the same condition, the lithium manganese iron phosphate is 10% to 20% higher than the lithium iron phosphate in energy density, so that the energy density of the battery system with mixed cells can be improved.

It should be noted that an available capacity of the lithium iron phosphate for charging and discharging at a low temperature drops sharply, and lithium plating is very likely to occur, which may cause safety accidents. However, in the implementation forms shown in FIG. 3 and FIG. 5, the lithium iron phosphate battery unit can be rapidly preheated by using the good low-temperature characteristic of the lithium manganese iron phosphate, improving the wide-temperature operating performance of the energy storage battery system. For example, in the battery pack with mixed cells shown in FIG. 5, the two types of cells are arranged alternately, so that the lithium iron phosphate cell is heated by using the good low-temperature characteristic of the lithium manganese iron phosphate, improving the overall performance of the battery pack.

In addition, due to the high cost of the lithium manganese iron phosphate, in the implementation forms shown in FIG. 4 and FIG. 6, the cost of the battery can be reduced by mixing a small amount of lithium manganese iron phosphate into the battery cluster including lithium iron phosphate.

FIG. 3 to FIG. 6 are only exemplary. In practical applications, the battery cluster includes both the lithium iron phosphate battery unit and the lithium manganese iron phosphate battery unit, both of which are the cell or the battery pack, and the number and series connection position are not limited, depending on the application environment.

The same or similar parts among the embodiments in this specification may be referred to each other, and each of the embodiments emphasizes differences from other embodiments. In particular, the system or system embodiment is basically similar to the method embodiment, and therefore is described relatively briefly. For relevant details, reference can be made to the corresponding description of the method embodiment. The system and system embodiments described above are only illustrative, in which the units described as separate components may or may not be physically separated, and the components shown as units may or may not be physical units, that is, may be located in one place, or distributed over multiple network elements. Some or all of the modules may be selected as needed to achieve the object of the solution of the embodiments. Those skilled in the art can understand and implement the solution without any creative effort.

Those skilled in the art may further realize that the units and algorithm steps of each example described in conjunction with the embodiments disclosed herein can be implemented by electronic hardware, computer software, or a combination of both. In order to clearly illustrate the interchangeability of hardware and software, the modules and steps of each example have been described in general terms of functionality in the above description. Whether these functions are performed in hardware or software depends on the specific application and design constraints of the technical solution. Those skilled in the art may implement the described functionality in various manners for each specific application, while such implementations should not be considered to be beyond the scope of the present disclosure.

Based on the above description of the disclosed embodiments, the features described in the different embodiments in this specification may be replaced or combined with each other, so that those skilled in the art can implement or use the present disclosure. Various modifications to these embodiments are apparent by those skilled in the art, and the generic principles defined herein may be implemented in other embodiments without departing from the spirit or scope of the present disclosure. Therefore, the present disclosure is not limited to the embodiments described herein, but should be in accordance with the broadest scope consistent with the principle and novel features disclosed herein.

## Claims

1. An SOC correction method for an energy storage system, wherein the energy storage system comprises at least one lithium manganese iron phosphate battery unit and at least one lithium iron phosphate battery unit connected in series; and the SOC correction method comprises:
determining whether the energy storage system is in an interval between two voltage plateau phases of the lithium manganese iron phosphate battery unit; and
correcting an SOC of the lithium iron phosphate battery unit based on an SOC of the lithium manganese iron phosphate battery unit in response to the energy storage system in the interval between the two voltage plateau phases.

2. The SOC correction method for an energy storage system according to claim 1, wherein the correcting an SOC of the lithium iron phosphate battery unit based on an SOC of the lithium manganese iron phosphate battery unit comprises:
determining the SOC of the lithium manganese iron phosphate battery unit as the SOC of the lithium iron phosphate battery unit.

3. The SOC correction method for an energy storage system according to claim 1, wherein the correcting an SOC of the lithium iron phosphate battery unit based on an SOC of the lithium manganese iron phosphate battery unit comprises:
correcting the SOC of the lithium iron phosphate battery unit based on a parameter of a curve segment corresponding to the interval between the two voltage plateau phases in an open circuit voltage, OCV, curve of the lithium manganese iron phosphate battery unit, and a voltage of the lithium iron phosphate battery unit.

4. The SOC correction method for an energy storage system according to claim 3, wherein the parameter of the curve segment comprises a voltage and an SOC,
wherein the correcting the SOC of the lithium iron phosphate battery unit based on a parameter of a curve segment and a voltage of the lithium iron phosphate battery unit comprises:
determining a slope of the curve segment based on the voltage and the SOC corresponding to the curve segment; and
determining the SOC of the lithium iron phosphate battery unit based on the slope of the curve segment and the voltage of the lithium iron phosphate battery unit.

5. The SOC correction method for an energy storage system according to claim 1, wherein the determining whether the energy storage system is in an interval between two voltage plateau phases of the lithium manganese iron phosphate battery unit comprises:
determining whether a voltage of the lithium manganese iron phosphate battery unit is between a minimum voltage of a first voltage plateau phase and a maximum voltage of a second voltage plateau phase, wherein the minimum voltage of the first voltage plateau phase is greater than the maximum voltage of the second voltage plateau phase; and
determining the energy storage system is in the interval between the two voltage plateau phases in response to the voltage of the lithium manganese iron phosphate battery unit between the minimum voltage of the first voltage plateau phase and the maximum voltage of the second voltage plateau phase.

6. The SOC correction method for an energy storage system according to any one of claims 1 to 5, wherein each of the at least one lithium manganese iron phosphate battery unit and the at least one lithium iron phosphate battery unit is a cell or a battery pack.

7. The SOC correction method for an energy storage system according to any one of claims 1 to 5, further comprising:
determining whether the energy storage system is at an end of charging and discharging; and
performing a conventional SOC correction on each of the at least one lithium manganese iron phosphate battery unit and the at least one lithium iron phosphate battery unit of the energy storage system in response to the energy storage system at the end of charging and discharging.

8. An energy storage system, comprising a battery management system, BMS, and at least one battery cluster controlled by the BMS, wherein
the battery cluster comprises one battery pack or at least two battery packs connected in series;
the one battery pack or the at least two battery packs comprises one cell or at least two cells connected in series;
at least one of the one battery pack or the at least two battery packs comprises at least one lithium iron phosphate cell;
at least one of the one battery pack or the at least two battery packs comprises at least one lithium manganese iron phosphate cell; and
the BMS is configured to perform the SOC correction method for an energy storage system according to any one of claims 1 to 7.

9. The energy storage system according to claim 8, wherein the battery cluster comprises the at least two battery packs connected in series, wherein
in two adjacent battery packs of the at least two battery packs, one of the two adjacent battery packs comprises only the lithium manganese iron phosphate cell, and the other battery pack of the two adjacent battery packs comprises only the lithium iron phosphate cell.

10. The energy storage system according to claim 8, wherein the battery cluster comprises the at least two battery packs connected in series, wherein
at least one of the at least two battery packs comprises only the lithium manganese iron phosphate cell; and
the other battery pack of the at least two battery packs comprises only the lithium iron phosphate cell.

11. The energy storage system according to claim 8, wherein
each of the one battery pack or at least two battery packs comprises at least two cells connected in series, and
two adjacent cells of the at least two cells are the lithium manganese iron phosphate cell and the lithium iron phosphate cell.

12. The energy storage system according to claim 8, wherein
each of the one battery pack or at least two battery packs comprises at least two cells connected in series;
at least one of the at least two cells is the lithium manganese iron phosphate cell; and
the other cell of the at least two cells is the lithium iron phosphate cell.

13. The energy storage system according to any one of claims 8 to 12, further comprising a power conversion system, PCS, or a DC/DC converter, wherein
the at least one battery cluster is connected to a direct-current side of the PCS or a battery side of the DC/DC converter;
an alternating-current side of the PCS is configured to connect a power grid and/or a load; and
a bus side of the DC/DC converter is configured to connect a direct-current bus of a renewable energy grid-connected power generation system.
